# EUROPEAN PATENT APPLICATION

(11) **EP 4 835 507 A1**
(43) Date of publication of application: **04.11.2026**
(21) Application number: 25173110.5
(22) Date of filing: 29.04.2025
(51) Int. Cl.: G01R 33/34

(54) **HIGH FREQUENCY HEAD COIL, MAGNETIC RESONANCE IMAGING SYSTEM COMPRISING THE COIL, AND METHOD OF USING THE SYSTEM.**

(71) Applicant: Koninklijke Philips N.V., 5656 AE Eindhoven (NL)
(72) Inventor: LIN, Dong, Eindhoven (NL); CAO, Yinzhi, Eindhoven (NL); SHEN, Chunhua, 5656AG Eindhoven (NL); YE, Shun, Eindhoven (NL); QIAN, Minli, Eindhoven (NL); XU, Qilin, Eindhoven (NL)
(74) Representative: Philips Intellectual Property & Standards

(57) **Abstract**

Disclosed herein is a head coil assembly. The head coil assembly comprises a head top portion comprising a head cover part, a head base portion comprising a head rest part, and a mechatronic connection module comprising a first connection part and a second connection part respectively positioned at different portions and configured to electrically connect and mechanically attach the head top portion to the head base portion. The first connection part comprises a first electrical connector, a lock member and a lock biasing element. The lock biasing element is configured to exert a bias force on the lock member. The second connection part comprises a second electrical connector and a lock recess. When the first electrical connector is engaged with the second electrical connector in a rear-front direction of the head coil assembly, the lock member is inserted into the lock recess in an up-down direction of the head coil assembly by the bias force to achieve the electrical connection and mechanical attachment between the head top portion and the head base portion.

## Description

### FIELD OF THE INVENTION

The invention pertains to magnetic resonance imaging, in particular to a radio frequency (RF) head coil for magnetic resonance imaging and method thereof.

### BACKGROUND OF THE INVENTION

A large static magnetic field is used by Magnetic Resonance Imaging (MRI) scanners to align the nuclear spins of atoms as part of the procedure for producing images within the body of a subject. This large static magnetic field is referred to as the B0 field or the main magnetic field. In MRI, the atomic spins are manipulated using gradient magnetic fields and radio frequency (RF) pulses. As the atomic spins relax, they emit radio-frequency signals which could be referred to as MRI signals. A radio-frequency receiver is used to digitize these MRI signals. This acquired data is referred to a k-space data. This k-space data may be collected and then a transform, such as an inverse Fourier transform, may be used to reconstruct the magnetic resonance image.

The radio frequency coil is an important component of MRI scanners and is used for generating radio frequency pulses to excite a scanned subject and generate magnetic resonance signals. In order to better acquire the magnetic resonance signal of the scanned subject and improve the signal-to-noise ratio of the image, local coils are widely utilized. Local coils are often designed for a particular scanned area, such as the ankle, the wrist, the spine, the head, etc.

The existing head coil typically comprises a head top part and a head base part which can be assembled together for imaging and disassembled for receiving and releasing the scanned subjects. More particularly, the head top part and the head base part need to be electrically and mechanically connected and disconnected in separate steps using two hands. Such cumbersome and complex workflows need to be operated frequently for receiving and releasing different scanned subjects. Moreover, if the head top coil falls due to negligence of operators, the head coil may not only be damaged but also injure the patient in place, leading to safety risk.

### SUMMARY OF THE INVENTION

The invention provides for a head coil assembly, a magnetic resonance imaging system, a method for magnetic resonance imaging using the magnetic resonance imaging system. The invention is defined by the independent claims. Advantageous embodiments are given in the dependent claims.

In one aspect a head coil assembly is disclosed. The head coil assembly comprises a head top portion comprising a head cover part, a head base portion comprising a head rest part, and a mechatronic connection module comprising a first connection part and a second connection part respectively positioned at different portions and configured to electrically connect and mechanically attach the head top portion to the head base portion. The first connection part comprises a first electrical connector, a lock member and a lock biasing element. The lock biasing element is configured to exert a bias force on the lock member. The second connection part comprises a second electrical connector and a lock recess. When the first electrical connector is engaged with the second electrical connector in a rear-front direction of the head coil assembly, the lock member is inserted into the lock recess in an up-down direction of the head coil assembly by the bias force to achieve the electrical connection and mechanical attachment between the head top portion and the head base portion. Owing to the mechatronic connection module, the workflow of assembling and disassembling the head coil assembly is simplifed and patient throughtput can be enhanced.

In one embodiment of the presention invention, the head coil assembly furthur comprieses a lock release mechanism (148) abutted against the lock member and configured to release the lock member from the lock recess by a motion of the lock member in the up-down direction of the head coil assembly.

In another embodiment of the presention invention, the first connection part is positioned at the head top portion and the second connection part is positioned at the head base portion.

In yet another emboidment of the present invention, a pivot member interconnecting the head cover part with the mechatronic connection module allows a rotation of the head cover part in relation to the mechatronic connection module. Owing to the rotational motion of the head cover part, reception and release of patients are more convenient.

In yet another emboidment of the present invention, the pivot memeber comprises a pivot shaft pivotably assembled into a fitting hollow of a lifting arm, and the assemble comprises an interference fit between the pivot shaft and the fitting hollow to provide a damping force for the lifting arm. As such, the damping force prevents a rapid descent of accidental falls experiened by the head cover part which is fixedly assembled together with the lifting arm.

In yet another embodiment of the present invention, the lock release mechanism further comprises a rotating shaft, a knob attached to the rotating shaft for driving a rotation of the rotating shaft; and a first rotary element attached to the rotating shaft for rotating in the same direction with the rotating shaft. An interaction between the first rotary element and the lock member caused by the rotational motion of the first rotary element drives the lock member to move in the up-down direction of the head coil assembly away from the lock recess.

In yet another embodiment of the present invention, the first connection part further comprises a power assist member for assisting the disconnection between the head top portion and head base portion by a motion of the power assist member towards a direction of a front of the head coil assembly. The lock release mechanism further comprises a second rotary element attached to the rotating shaft for rotating in the same direction with the rotating shaft. An interaction between the second rotary element and the power assist member caused by the rotational motion of the second rotary element drives the motion of the power assist member towards the direction of the front of the head coil assembly.

In another aspect, a magntic resonance imaging system comprising the head coil assembly is disclosed.

In yet another aspect, a method for magnetic resonance imaging using the magnetic resonance imaging system. The method comprieses the steps of electrically connecting and mechanically attaching the head top portion to the head base portion by a mechatronic connection module to set the heal coil assembly in a closed state, acquiring by the magnetic resonance imaging system k-space data using the head coil assembly in the closed state, and reconstructing a magnetic resonance image using the k-space data.

### BRIEF DESCRIPTION OF THE DRAWINGS

In the following embodiments of the invention will be described, by way of example only, and with reference to the drawings in which:
Fig. 1A illustrates a perspective view of a head coil assembly 100 in a closed state according to one embodiment of the present invention.
Fig. 1B illustrates a perspective view of the head coil assembly 100 in an open state according to one embodiment of the present invention.
Fig. 2A illustrates a perspective view of the head top portion 110 in Fig. 1A according to one embodiment of the present invention.
Fig. 2B illustrates a perspective view of the head base portion 120 in Fig. 1A according to one embodiment of the present invention.
Fig. 3A illustrates the head coil assembly 100 with an exploded view of the first connection part 132 according to one embodiment of the present invention.
Fig. 3B illustrates an exploded view of the first connection part 132 viewed from another angle according to one embodiment of the present invention.
Fig. 3C illustrates a perspective view of the head top portion 110 with an upper housing portion removed.
Fig. 3D illustrates an exploded view of the pivot member 319 according to one embodiment of the present invention.
Fig. 4 illustrates an example of a magnetic resonance imaging system 400 that incorporates the head coil assembly 100 of Fig. 1A according to one embodiment of the present invention.
Fig. 5 illustrates a flowchart 500 of a method for operating the head coil assembly 100 according to one embodiment of the present invention.

### DETAILED DESCRIPTION OF EMBODIMENTS

Like numbered elements in these figures are either equivalent elements or perform the same function. Elements which have been discussed previously will not necessarily be discussed in later figures if the function is equivalent.

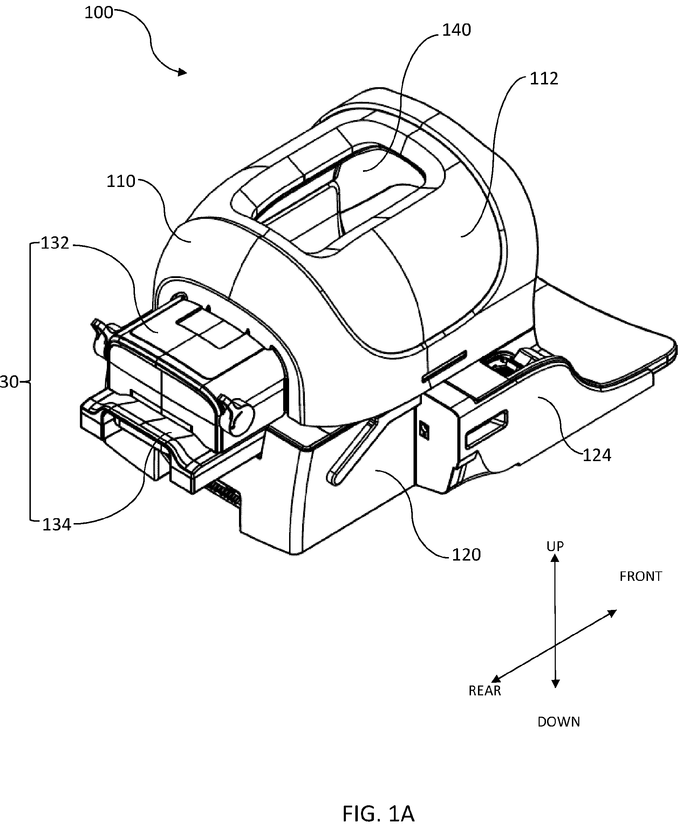

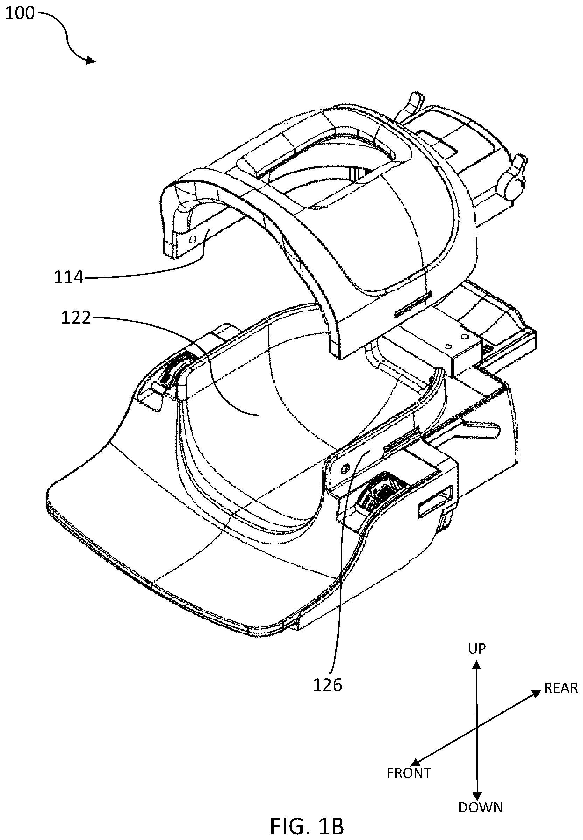

Fig. 1A illustrates a perspective view of a head coil assembly 100 in a closed state according to one embodiment of the present invention. Fig. 1B illustrates a perspective view of the head coil assembly 100 in an open state according to one embodiment of the present invention. Referring to Fig.1A and Fig. 1B, the head coil assembly 100 includes a head top portion 110 and a head base portion 120. In the closed state of the head coil assembly 100, a mechatronic connection module 130 electrically and mechanically interconnects the head top portion 110 to the head base portion 120. The mechatronic connection module 130 further comprises a first connection part 132 and a second connection part 134 respectively positioned at different portions of the head coil assembly 100. In the exemplary embodiment shown in Fig.1A and Fig. 1B, the first connection part 132 is assembled together with a head cover part 112 to form the head top portion 110, and the second connection part 134 is assembled together with a head rest part 122 to form the head base portion 120. By electrically and mechanically connecting the first connection part 132 to the second connection part 134, the head cover part 112 and the head rest part 122 are engaged with each other to form a head receiving chamber 140. Advantageously, engagement between the first and second connection parts of the mechatronic connection module 130 achieves the secure electrical connection and mechanical attachment between the head top portion 110 and the head base portion 120 in a single step, and in turn sets the head coil assembly 100 in the closed state of Fig. 1A. In the embodiment of Fig. 1A, a head base support 124 configured to be placed between the head base portion 120 and a patient couch is further provided for supporting the head base portion 120. Alternatively, the head base support 124 can be an integral part of the head base portion 120 so as to form a single configuration of the head base operable for being placed on the patient couch directly.

For the purpose of describing the motions of components of the head coil assembly 100 relevant to each other, the direction from position of the mechatronic connection module 130 to position of an opening of the head receiving chamber 140 is defined as a rear-to-front direction and the direction from top surface of the head top portion 110 to bottom surface of the head base portion 120 is defined as an up-to-down direction. To set the head coil assembly 100 from the closed state to the open state, the head top portion 110 as shown in Fig.1A is moved backwards in relation to the head base portion 120 and the backward movement electrically disconnects and mechanically detaches the head top portion 110 from the second base portion 120 simultaneously in a single step. At an end position of the backward movement, the head top portion 110 is further moved upwardly to be mechanically disconnected from the head base portion 120. As such, the head top portion 110 is electrically and mechanically disconnected from the head base portion 120 in the open state as shown in Fig. 1B. To set the head coil assembly 100 from the open state to the closed state, the head top portion 110 as shown in Fig. 1B can be moved downwards to be electrically and mechanically connected to the head base portion 120. The head top portion 110 is further moved forwards and the forward movement electrically connects and mechanically attaches the head top portion 110 to the head base portion 120 in a single step. As such, the head top portion 110 is electrically and mechanically connected to the head base portion 120 in the closed state as shown in Fig. 1A. Optionally, connecting portions of left and right sides of the head cover part 112 and the head rest part 122 that are connected to each other in the closed state form top engagement members 114 and bottom engagement members 126, respectively. The engagement between the top and bottom engagement members 114 and 126 can facilitate the positioning of the head top portion 110 in relation to the head base portion 120 and further guide the upward/downward and backward /forward movement to ensure a smooth and secure transition between the closed and open states.

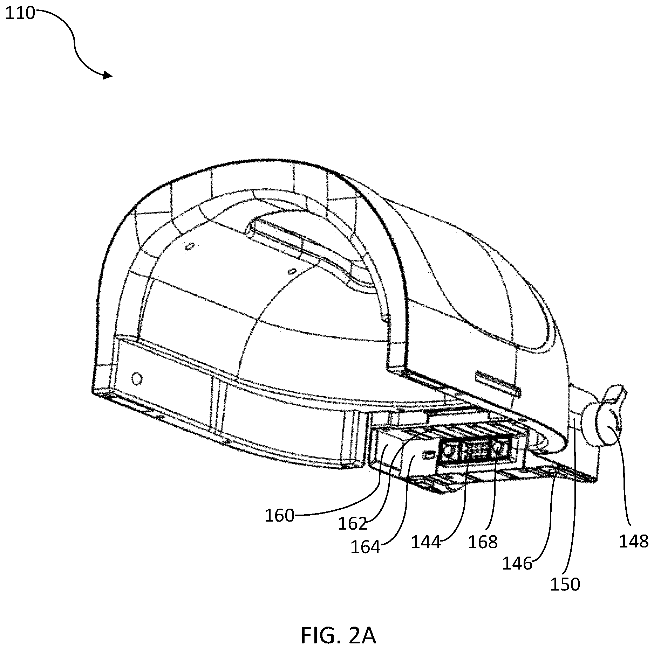

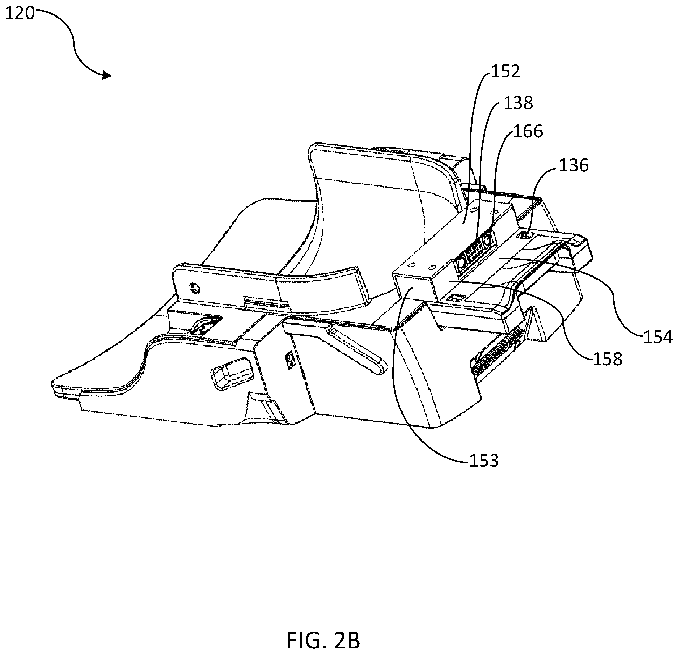

Fig. 2A illustrates a perspective view of the head top portion 110 according to one embodiment of the present invention. Fig. 2B illustrates a perspective view of the head base portion 120 according to one embodiment of the present invention. With reference to Fig. 2A and Fig. 2B, the electronic and mechanical connection between the head top portion 110 and the head base portion 120 are described in more details. The first connection part 132 comprises a first electrical connector 144, a lock member 146 and a lock release mechanism 148. In Fig. 2A, two lock members 146 are shown as an example. The first electrical connector 144, the lock members 146 and at least parts of the lock release mechanism 148 are housed in a first housing 150. By exerting a biasing force on the lock member 146, the lock member 146 is biased to move downwards through an aperture in the bottom of the first housing 150. The first connection part 132 further comprises side connecting surfaces 160 and an upper connecting surface 162 extending forwards from a front side 164 of the first housing 150. Referring to Fig. 2B, a second electrical connector 138 is housed in a second housing 152 which is shaped to engage with the side connecting surfaces 160 and the upper connecting surface 162 of the first housing 150 in the closed state of the head coil assembly. Furthermore, a bottom connecting surface 154 extending backwards from a rear side 158 of the second housing 152 is provided to be engaged with the bottom of the first housing 150 in the closed state of the head coil assembly 110. A lock recess 136 is further formed in the bottom connecting surface 154. When the head top portion 110 is placed on the head base portion 120, the bottom of the first housing 150 mechanically connects to the bottom connecting surface 154 and the lock member 146 is biased to press against the bottom connecting surface 154 by the biasing force. The head top portion 110 slides forwards in relation to the head base portion 120 and the forward movement allows the lock member 146 to be inserted into the lock recess 136 and locked in position. At the locked position, the first and second electrical connectors 144 and 138 are securely engaged with each other. The secure engagement means that the first and second electrical connectors are electrically coupled to each other and mechanically attached to each other securely. In other words, when the first and second electrical connectors are engaged with each other in an engagement position where the simultaneous electrical and mechanical connection between the head top portion 110 and the head base portion 120 is completed, the engagement between the first and second electrical connectors is automatically locked in position to further secure the electrical and mechanical connection by insertion of lock member 146 into the lock recess 136, e.g., without manual intervention. Advantageously, sides 153 of the second housing 152 and side connecting surfaces 160 serve as corresponding upper and bottom engagement members respectively to guide the positioning and movements during transitions between the closed and open states. To achieve more precise positioning for protection of connector pins during secure engagement between the first and second electrical connectors 138 and 144, holes 166 and corresponding posts 168 arranged adjacent to respective electrical connectors 138 and 144 are engaged with each other.

By exerting a release force on the lock member 146 by the lock release mechanism 148, the lock member 146 moves upwardly out of the lock recess 136. Then, the head top portion 110 is moved backwards and the backward movement electrically disconnects and mechanically detaches the first electrical connector 144 from the second electrical connector 138 simultaneously in a signal step. As such, the head top portion 110 is electrically disconnected and mechanically detached from the second base portion 120 simultaneously in a single. At the end position of the backward movement, the head top portion 110 is further moved upwardly to be mechanically disconnected from the head base portion 120 so as to set the head coil assembly 100 to the open state.

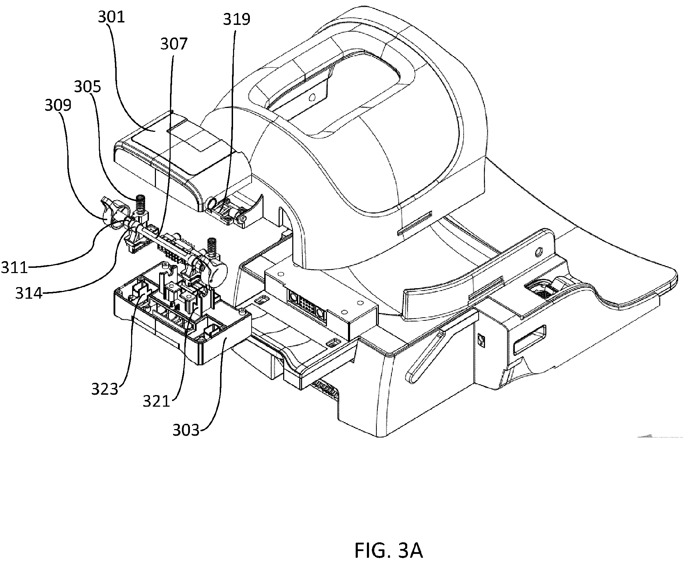

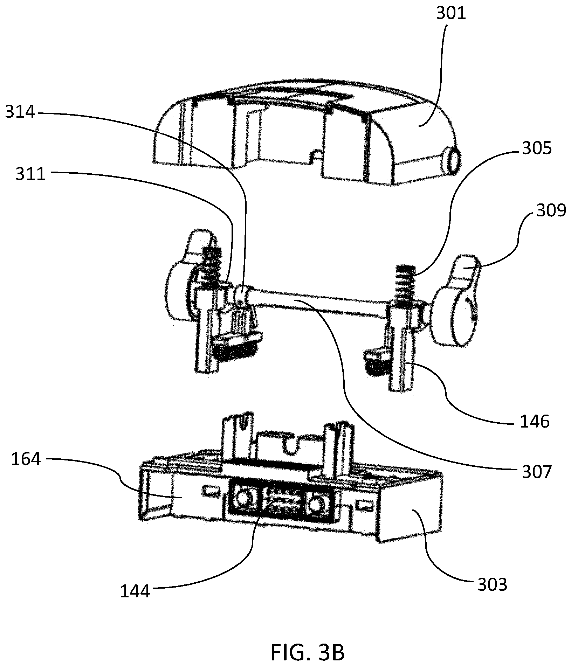

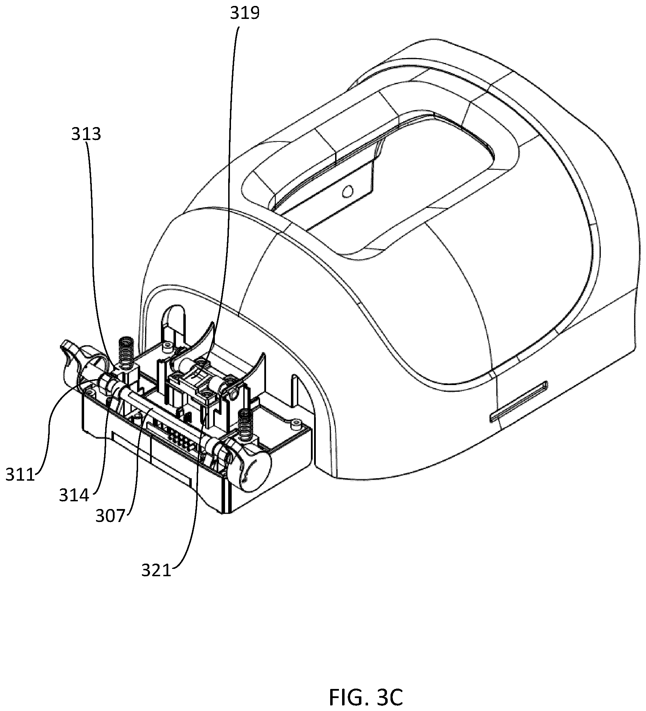

Fig. 3A illustrates the head coil assembly 100 with an exploded view of the first connection part 132 according to one embodiment of the present invention. Fig. 3B illustrates an exploded view of the first connection part 132 viewed from another angle according to one embodiment of the present invention. Fig. 3C illustrates a perspective view of the head top portion 110 with an upper housing portion removed. Referring to Fig. 3A to Fig. 3C, the first housing 150 of the first connection part 132 comprising an upper housing portion 301 and a lower housing portion 303 which are attached to each other to provide an enclosure for components of the first connection part 132. The lock member 146 is biased by a biasing member to move downwards. In the embodiment of Fig. 3A, the biasing member 148 is formed by a tension spring 305 arranged between a frame of the upper housing portion 301 and the lock member 146. When the head top portion 110 is placed on the top base portion 120, the downward movement enables the lock member 146 to move through an aperture in the lower housing portion 303 and press against the upper connecting surface 154. The head top portion 120 is then moved forwards and the forward movement allows the lock member 140 locked in the lock recess 136. To release the lock member 146 from the lock recess 136, the lock release mechanism 148 exerts an external force on the lock member 146 to allow its upward movement.

In the embodiment of Fig. 3A to Fig. 3C, the lock release mechanism 148 includes a rotating shaft 307, a knob 309 and a first rotary element 311. Bothe the knob 309 and the first rotary element 311 are fixedly attached to the rotating shaft 307. The first rotary element 311 is arranged to be abutted against a protruding part 313 of the lock member 146 as shown in Fig. 3C. By rotating the knob 309, the rotating shaft 307 and the first rotary element 311 rotate in the same direction owing to the fixed attachment. Via the rotational motion, the first rotary element 311 exerts an upward-directed force upon the protruding part 313 of the lock member 146 and this upward-directed force allows the lock member 146 to move upwardly until being unlocked from the lock recess 136. In the embodiment of Fig. 3A to Fig. 3C, both ends of the rotating shaft 307 have the knob 307 installed to facilitate an operator to select the more convenient knob when positioned on different sides of the head coil assembly 100. In a similar way, Fig. 3A to Fig. 3C show the exemplary embodiment with two lock members, first rotatory elements, tension springs and various other components. However, it is appreciated by the skilled the art that a single one of respective component can achieve associated locking, unlocking, power assisting and various other functionalities as well and the number of components shown in these figures are only exemplary and not intended to limit the scope, applicability, or configuration in any way.

Optionally, the lock release mechanism 148 further includes a second rotary element 314 fixedly attached to the rotating shaft 307. The second rotary element 314 is arranged to be abutted against a protruding part 317 of a power assist member 315 which is capable of moving in a front-rear direction of the head coil assembly 100. By rotating the knob 309, the rotating shaft 307 and the second rotary element 314 rotate in the same direction owing to the fixed attachment. Via the rotational motion, the second rotary element 314 exerts a front-directed force upon the protruding part 317 of the power assist member 315 and this front-directed force allows the power assist member 315 to move forwards through an aperture in the front side 164 of the first housing 150. The forward movement further enables the power assist member 315 to press against the rear side 158 of the second housing 152. The reaction force experienced by the power assist member 315 due to such pressing assists the first electrical connector 144 to be electrically disconnected and mechanically detached from the second electrical connector 138. To hold the lock member 146 and power assist member 315 in position and guide respective up-down motion and front-rear motion, an inverted T-shaped sleeve 323 arranged in the lower housing portion 303 is further provided for the passages of the lock member 146 and power assist member 315 through respective front side 164 and rear side 158 in one embodiment. Advantageously, by turning the knob 309 of the lock release mechanism 148, the head top portion 110 can be unlocked from the locked position and provided with an assistant force for being electrically disconnected and mechanically detached from the head base portion 120 in a single step.

Optionally, the head coil assembly 100 further includes a pivot member 319 interconnecting the head cover part 112 with the first connection part 132. More specifically, the pivot member 319 is interconnected between the head cover part 112 and a support member 321 arranged in the lower housing portion 303. A height of the support member 321 is well designed to allow the bottoms of the head cover part 112 and the first housing 150 on the same horizontal plane. By using the pivot member 319, the head cover part 112 is enabled to rotate with respect to the first connection part 132. As such, when the head coil assembly 100 is in the closed state, it is more convenient to flip the head cover part 112 to receive or release a patient than cumbersome and frequent transitions between the closed and open states of the head coil assembly 100. Advantageously, the workflow is significantly improved and the patient throughput is enhanced.

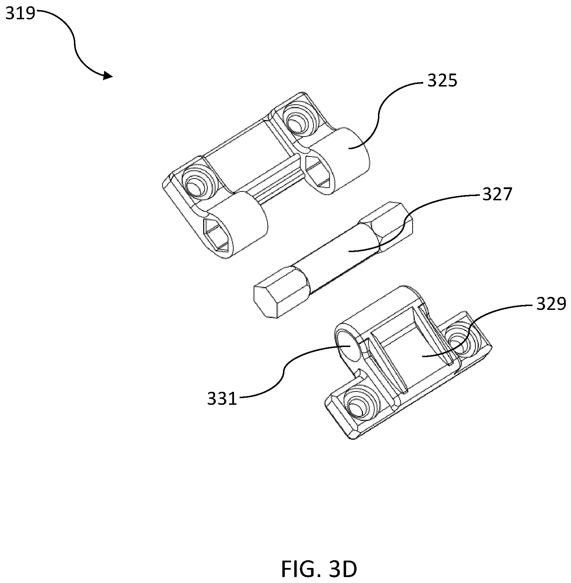

Fig. 3D illustrates an exploded view of the pivot member 319 according to one embodiment of the present invention. The pivot member 319 comprises a support arm 325, a pivot shaft 327 and a lifting arm 329. The support arm 325 is fixedly interconnected between the support member 321 and the pivot shaft 327. The lifting arm 329 is pivotably connected to the pivot shaft 327 to allow the rotation of the lifting arm 329 around the pivot shaft 327. More advantageously, to fit the pivot shaft 327 into a fitting hollow 331 of the lifting arm 329, an intentional overlap between the pivot shaft 327 and the fitting hollow 331, is designed to provide an interference fit. In the interference fit, the dimension of the pivot shaft 327 is larger than the dimension of the fitting hollow 331 to provide the intentional overlap and the overlap creates a damping force for the lifting arm 329. When the head cover part 112 is fixedly attached to the lifting arm 329, the damping force allows risks caused by accident falls of the the head cover part 112 eliminated or reduced as descent of the head cover part 112 is slow due to the damping force.

The coil assembly 100 described according to above figures is presented as an exemplary embodiment. Alternatively, it is conceivable to the skilled in the art that positions of the lock member and lock recess can be switched, that is, arranged in the second connection part and the first connection part, respectively. Therefore, it should be appreciated that a vast number of variations exist. It should also be appreciated that the exemplary embodiment or exemplary embodiments are only examples, and are not intended to limit the scope, applicability, or configuration in any way. Rather, the foregoing detailed description will provide those skilled in the art with a convenient road map for implementing an exemplary embodiment, it being understood that various changes may be made in the function and arrangement of elements described in an exemplary embodiment without departing from the scope as set forth in the appended claims and their legal equivalents.

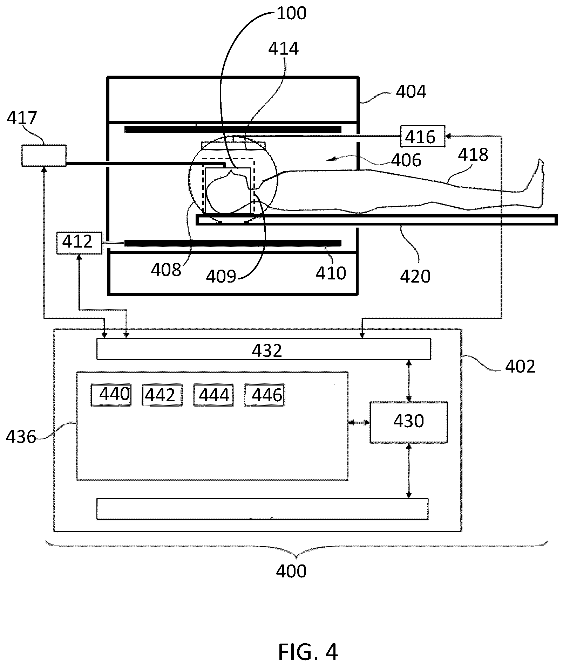

Fig. 4 illustrates an example of a magnetic resonance imaging system 400 that incorporates the head coil assembly 100 of Fig. 1A according to one embodiment of the present invention. The magnetic resonance imaging system 400 is shown as comprising a magnet 404, a computer 402, and the head coil assembly 100.

The magnetic resonance imaging system 400 comprises the magnet 404. The magnet 404 is a superconducting cylindrical type magnet with a bore 406 through it. It is also possible to use both a split cylindrical magnet and a so-called open magnet. A split cylindrical magnet is similar to a standard cylindrical magnet, except that the cryostat has been split into two sections to allow access to the isoplane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 406 of the cylindrical magnet 404, there is an imaging zone 408 where the magnetic field is strong and uniform enough to perform magnetic resonance imaging. A field of view 409 is shown within the imaging zone 408. The k-space data are acquired for the field of view 409. The region of interest could be identical with the field of view 409 or it could be a sub volume of the field of view 409. A subject 418 is shown as being supported by a subject support 420 such that at least a portion of the subject 418 is within the imaging zone 308 and the field of view 309.

Within the bore 406 of the magnet there is also a set of magnetic field gradient coils 410 which is used for the acquisition of measured k-space data to spatially encode magnetic spins within the imaging zone 408 of the magnet 404. The magnetic field gradient coils 410 are connected to a magnetic field gradient coil power supply 412. The magnetic field gradient coils 410 are intended to be representative. Typically, magnetic field gradient coils 410 contain three separate sets of coils for spatial encoding in three orthogonal spatial directions. A magnetic field gradient power supply supplies current to the magnetic field gradient coils. The current supplied to the magnetic field gradient coils 410 is controlled as a function of time and may be ramped or pulsed.

There is a magnetic resonance imaging transmit coil 414 that is connected to a transmitter 416. Additionally, a radio-frequency receiver 417 is shown as being connected to the head coil assembly 100.

The magnetic resonance imaging system 400 is shown as being controlled by a computer system (local controller) 402. The local controller 402 is shown as comprising a processor 430 which may represent one or more processors or computational system located at one or more locations. The processor 430 is further shown as being in communication with a hardware interface 432, and optional user interface 434, and a memory 436. The hardware interface 432 of the local controller 402 that is shown as being connected to the radio-frequency receiver 417, the magnetic field gradient coil power supply 412, and the transmitter 416.

The local controller 402 is further shown as comprising a computational system 430. The local controller 402 and the computational system 430 may be one or more computer systems or computational systems located at one or more locations. The hardware interface 432 may enable the computational system 430 to communicate with and to control other components of the magnetic resonance imaging system 400. The computational system 430 is further shown as being in communication with an optional user interface 334 and a memory 336. The memory 336 is intended to represent different types of memory which may be accessible to the computational system 330.

The memory 436 is shown as containing machine-executable instructions 440. The machine-executable instructions 440 enable the computational system 430 to perform various data and image processing tasks as well as to control the magnetic resonance imaging system 400. The memory 436 is further shown as storing pulse sequence commands 442. The pulse sequence commands 442 are commands or data which may be converted into such commands for controlling the magnetic resonance imaging system 400 to acquire k-space data. Typically, the pulse sequence commands 442 are in the form of a timing diagram. The memory 436 is further shown as storing a k-space data 444 that was acquired by controlling the magnetic resonance imaging system 400 with the pulse sequence commands 442. The memory 436 is further shown as storing a magnetic resonance image 446 that was reconstructed from the k-space data 444.

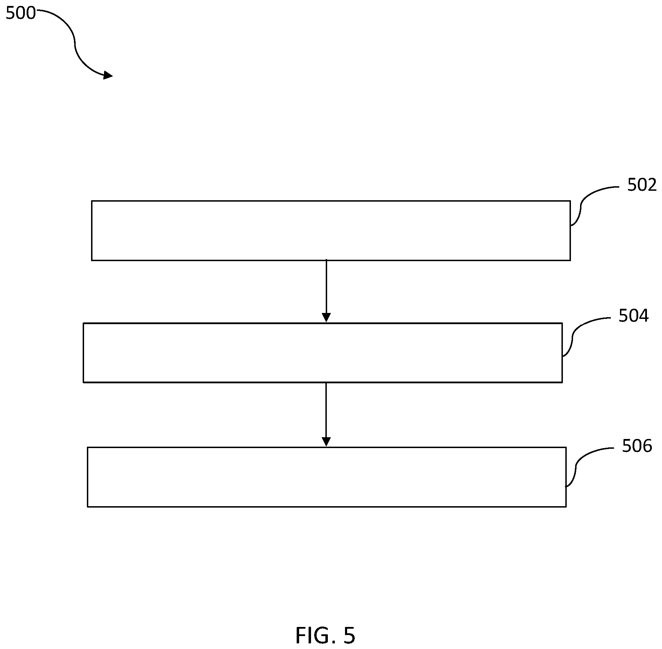

Fig. 5 illustrates a flowchart 500 of a method for operating the head coil assembly 100 according to one embodiment of the present invention. At step 502, the head top portion 110 is electrically connected and mechanically attached to the head base portion 120 simultaneously in a single step by the mechatronic connection module 130. As such, the head coil assembly 100 is set to the closed state and ready for scan. At step 504, the magnetic resonance imaging system 400 acquires k-space data 444 using the head coil assembly 100 in the closed state. At step 506, magnetic rsonance image 446 is reconstructed using the acquired k-space data 444. In one embodiment, the flowchart 500 may further comprising the step of electrically disconnecting and mechanically detaching the head top portion 110 from the head base portion 120 simultaneously in a single step by the mechatronic connection module 130. In one embodiment, the flowchart 500 may further comprise the steps of flipping the head cover part 112 up to allow access to and release from a head receiving chamber 140 and flipping the head cover part 112 down to form the head receiving chamber 140 for accommodating head of a subject. In one embodiment, the flowchart 500 may further comprises the steps of unlocking the head top portion 110 from the head base portion 120 by turning a knob 309 of the lock release mechanism 148, and simultaneously providing an assistance force for electrically disconnecting and mechanically detaching the head top portion 110 from the head base portion 120 by turning the knob 309 of the lock release mechanism 148.

It is understood that one or more of the aforementioned examples or embodiments of the invention may be combined as long as the combined embodiments are not mutually exclusive.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

Although the invention has been described in reference to specific embodiments, it should be understood that the invention is not limited to these examples only and that many variations of these embodiments may be readily envisioned by the skilled person after having read the present disclosure. The invention may thus further be described without limitation and by way of example only by the following embodiments. The following embodiments may contain preferred embodiments. Accordingly, the term "clause" as used therein may refer to such a "preferred embodiment".

## Claims

1. A head coil assembly (100) comprising:
- a head top portion (110) comprising a head cover part (112);
- a head base portion (120) comprising a head rest part (122); and
- a mechatronic connection module (130) comprising a first connection part (132) and a second connection part (134) respectively positioned at different portions (110, 120) and configured to electrically connect and mechanically attach the head top portion (110) to the head base portion (120), wherein the first connection part (134) comprises a first electrical connector (144) , a lock member (146) and a lock biasing element (305), wherein the lock biasing element (305) is configured to exert a bias force on the lock member (146), wherein the second connection part (134) comprises a second electrical connector (138) and a lock recess (136), wherein the first electrical connector (144) is configured to be engaged with the second electrical connector (138) in a rear-front direction of the head coil assembly (100), and wherein when the first and second electrical connector are engaged with each other, the lock member (146) is configured to be inserted into the lock recess (136) in an up-down direction of the head coil assembly (100) by the bias force to achieve the electrical connection and mechanical attachment between the head top portion (110) and the head base portion (120).

2. The head coil assembly (100) of claim 1 further comprising:
- a lock release mechanism (148) abutted against the lock member (146) and configured to release the lock member (146) from the lock recess (136) by a motion of the lock member (146) in the up-down direction of the head coil assembly (100).

3. The head coil assembly (100) of any one of the preceding claims, wherein the first connection part (132) is positioned at the head top portion (110) and the second connection part (134) is positioned at the head base portion (120).

4. The head coil assembly (100) of any one of the preceding claims, further comprising:
- a pivot member (319) interconnecting the head cover part (112) with the mechatronic connection module (130) to allow a rotation of the head cover part (112) in relation to the mechatronic connection module (130).

5. The head coil assembly (100) of claim 4, wherein the pivot assembly (319) comprises a pivot shaft (327) pivotably assembled into a fitting hollow (331) of a lifting arm (329), and wherein the assemble comprises an interference fit between the pivot shaft (327) and the fitting hollow (331) to provide a damping force for the lifting arm (329).

6. The head coil assembly (100) of any one of the preceding claims, wherein the lock release mechanism (148) further comprises:
- a rotating shaft (307);
- a knob (309) attached to the rotating shaft (307) for driving a rotation of the rotating shaft (307); and
- a first rotary element (311) attached to the rotating shaft (307) for rotating in the same direction with the rotating shaft (307), wherein an interaction between the first rotary element (311) and the lock member (146) caused by the rotational motion of the first rotary element (311) drives the lock member (146) to move in the up-down direction of the head coil assembly (100) away from the lock recess (136).

7. The head coil assembly (100) of claim 6, wherein the first connection part (132) further comprises a power assist member (315) for assisting the disconnection between the head top portion (110) and head base portion (120) by a motion of the power assist member (315) towards a direction of a front of the head coil assembly (100), and wherein the lock release mechanism further (148) comprises a second rotary element (314) attached to the rotating shaft (307) for rotating in the same direction with the rotating shaft (307), wherein an interaction between the second rotary element (314) and the power assist member (315) caused by the rotational motion of the second rotary element (314) drives the motion of the power assist member (315) towards the direction of the front of the head coil assembly (100).

8. The head coil assembly (100) of any one of the preceding claims, wherein the first connection part (132) further comprises a first housing (150) for enclosing a first electrical connector (144) and the lock member (146) and side connecting surfaces (160) and an upper connecting surface (162) extending forwards from a front side (164) of the first housing (150), the second connection part (134) further comprises a second housing (152) for enclosing a second electrical connector (138) and a bottom connecting surface (154) extending backwards from a rear side (158) of the second housing (152), and wherein the first and second housings (150, 152) and corresponding connecting surfaces of the first and second connection parts (132, 134) are shaped to engage the first and second electrical connectors (144, 138) with each other.

9. The head coil assembly (100) of claim 8, wherein the lock recess (136) is formed in the bottom connecting surface (154).

10. The head coil assembly (100) of any one of the preceding claims, wherein the lock member (146) is biased to press against the bottom connecting surface (154) by the biasing force when the head top portion (110) is arranged on the head base portion (120), and wherein the lock member (146) is locked in the lock recess (136) by the biasing force when the head top portion (110) is securely engaged with the head base portion (120).

11. The head coil assembly (100) of any one of the preceding claims, wherein the lock biasing element (305) comprises a tension spring.

12. A magnetic resonance imaging system (400) comprising the head coil assembly (100) of any one of claims 1-11.

13. A method (500) for magnetic resonance imaging using the magnetic resonance imaging system (400) of claim 12, wherein the method comprises the steps of:
- electrically connecting and mechanically attaching (502) the head top portion (110) to the head base portion (120) by a mechatronic connection module (130) to set the head coil assembly (100) in a closed state;
- acquiring (504) by the magnetic resonance imaging (400) system k-space data (444) using the head coil assembly (100) in the closed state; and
- reconstructing (506) a magnetic resonance image (446) using the k-space data (444).

14. The method (500) of claim 13, further comprising:
- flipping the head cover part (112) down to form the head receiving chamber (140) for accommodating head of a subject; and
- flipping the head cover part (112) up to allow access to and/or release from the head receiving chamber (140) by the subject.

15. The method (500) of any one of claims 13-14, further comprising:
unlocking the head top portion (110) from the head base portion (120) by turning a knob (309) of the lock release mechanism (148); and
simultaneously providing an assistance force for disconnecting the head top portion (110) from the head base portion (120) by the turning of the knob (309).
